Europäisches Patentamt

European Patent Office

Office européen des brevets

(19)

(11) Publication number: **0 250 251**
**A2**

(12) **EUROPEAN PATENT APPLICATION**

(21) Application number: **87305449.8**

(22) Date of filing: **19.06.87**

(51) Int. Cl.⁴: **H 01 L 23/56**

(30) Priority: **20.06.86 GB 8615144**

(43) Date of publication of application:
**23.12.87 Bulletin 87/52**

(84) Designated Contracting States: **DE FR IT**

(71) Applicant: **THE M-O VALVE COMPANY LIMITED**
**Brook Green Works**
**Hammersmith London, W6 7PE (GB)**

(72) Inventor: **Rhodes, Christopher John**
**6 Willow Way**
**Hemel Hempstead Hertfordshire (GB)**

**Taylor, Eric Albert**
**7 Roy Grove**
**Hampton Middlesex (GB)**

**Williams, Roger Antony Keith**
**106 Church Lane**
**Tooting Broadway London SW17 (GB)**

**Savory, Eric Victor**
**216 Baldwins Lane**
**Croxley Green Rickmansworth Herts (GB)**

(74) Representative: **MacKenzie, Ian Alastair Robert**
**The General Electric Company, p.l.c. Central Patent**
**Department Wembley Office Hirst Research Center East**
**Lane**
**Wembley Middlesex HA9 7PP (GB)**

(54) **Feed-through strips.**

(57) The invention concerns the manufacture of microwave feed-throughs. Two ceramic laminae (30, 40) are used. The first (30) is formed with a plurality of parallel slots (32) which define webs (34) of a thickness equal to the desired thickness of the proposed package base wall through which the strips will in use pass. The webs are metallised. The second lamina (40) has one side metallised with parallel tracks (42) each having a width equal to the required width of the final microstrip. The two laminae are placed in register and bonded together. The matrix so formed is cut into strips which have two sides metallised and are then fired. Finally the strips are reassembled into a matrix and divided into individual microstrip feed-throughs.

*Fig.1.*

**Description**

Feed-Through Strips

The present invention concerns microwave feed-through strips. These are components which are mounted in the walls of hermetically sealed semi-conductor chip packages so as to conduct microwave energy from a semi-conductor device housed within the package.

In the production of miniature microwave and digital I.C. packages a need exists for feed-through strips which are extremely small yet have a controlled characteristic impedance. To produce such feed-throughs individually presents severe handling problems and very high cost.

The present invention has for one object to provide a method for the bulk manufacture of microwave feed-through strips.

Accordingly fron one aspect the invention comprises a process for manufacturing microwave feed-through strips comprising forming a first lamina with a plurality of parallel slots so as to define between the slots webs of thickness equal to the desired final thickness of the proposed package base wall, metallising one face of the lamina around said slots, metallising parallel tracks on a second lamina, the tracks each having the width required for the striplines of the individual feed-through strips and in addition metallising the whole of the reverse face of this second lamina, placing the two laminae in registration and firing the matrix so formed.

The process may also comprise individual strips each containing a plurality of potential feed-through strips, and subdividing each individual strip so formed into separate feed-through strips.

Preferably the laminae are of ceramic material. The individual strips formed by slitting the matrix preferably have those sides not carrying the actual striplines metallised before subdivision into individual feed-through strips.

The laminae may be treated with glass frit prior to the firing of the matrix so as to ensure hermeticity.

From a second aspect the invention also consists in a microwave feed-through strip manufactured by the process as set out hereinbefore.

In order that the present invention may be more readily understood, a process for manufacturing microwave feed-throughs in accordance with the invention will now be described by way of example and with reference to the accompanying drawings, in which

Figure 1 is an isometric view of the base portion of an I.C. package incorporating a plurality of microwave feed-throughs,

Figure 2 is a similar view of a single microwave feed-through according to the invention,

Figure 3 is a plan view of a lamina used in the process according to the invention,

Figure 3A is an edge view of the lamina of Figure 3,

Figure 4 is a plan view of a second lamina for use in the process,

Figure 4A is an edge view of the lamina of Figure 5,

Figure 5 is a plan view of the laminae of Figures 3 and 5A superimposed,

Figure 5A is an edge view of the superimposed lamina, and

Figure 6 and Figure 6A are side and plan views of strips cut from the sumperimposed lamina of Figure 5.

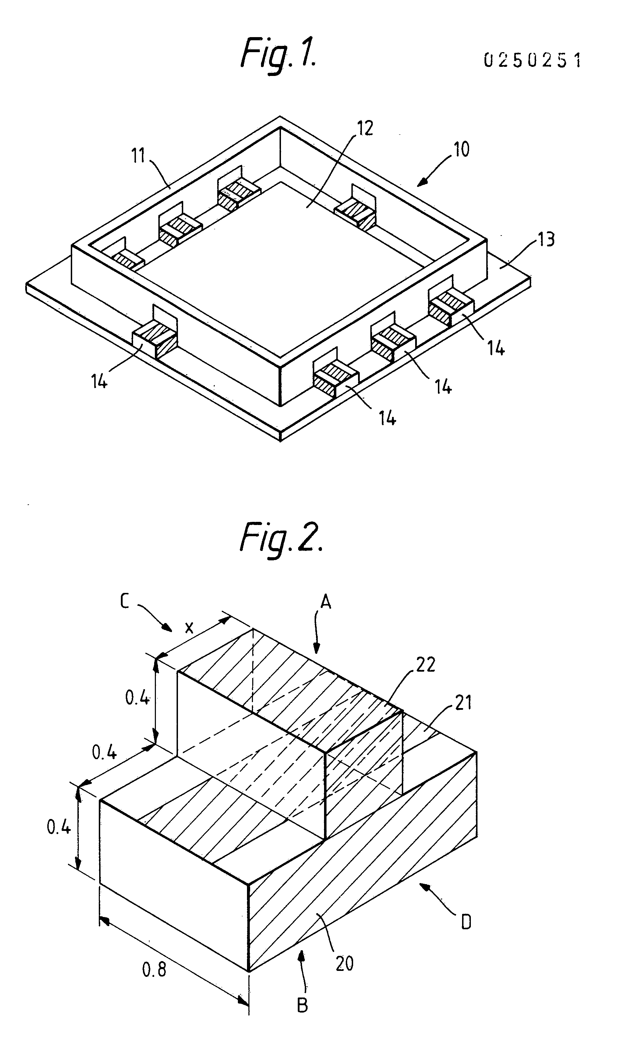

Referring now to the drawings, Figure 1 shows the base portion 10 of an I.C. package. The complete package normally includes a semi-conductor chip and a lid sealed to the base portion 10. Both these integers are entirely conventional and have not been shown. The base element 10 has a rectangular wall 11 surrounding a raised central portion 12 on which the semi-conductor chip would be mounted, the wall and central portion being mounted on a base plate 13. A variety of suitable known materials can be used in the fabrication of the base portion 10, one of which is nickel iron.

The wall 11 is formed with eyelet openings and a microwave feed-through strip 14 is sealed in each of these openings.

Figure 2 shows one of the microwave feed-through strips in greater detail.

The feed-through strip comprises a rectangular block 20 of ceramic material having its sides and base B, C and D metallised and carrying on its upper surface a microstrip 21. Mounted on block 20 is a further, smaller, rectangular block 22 also of ceramic material which has its sides and upper surface A, C and D metallised.

When the feed-through strip is positioned as shown in Figure 1 the block 22 forms a non-conductive seal in the opening in the wall of the base portion of the package. The dimensions shown in Figure 2 are in millimeters though of course these dimensions can be varied.

The process for fabricating a feed-through strip of the kind shown in Figure 2 will now be described with reference to the remaining figures of the accompanying drawings.

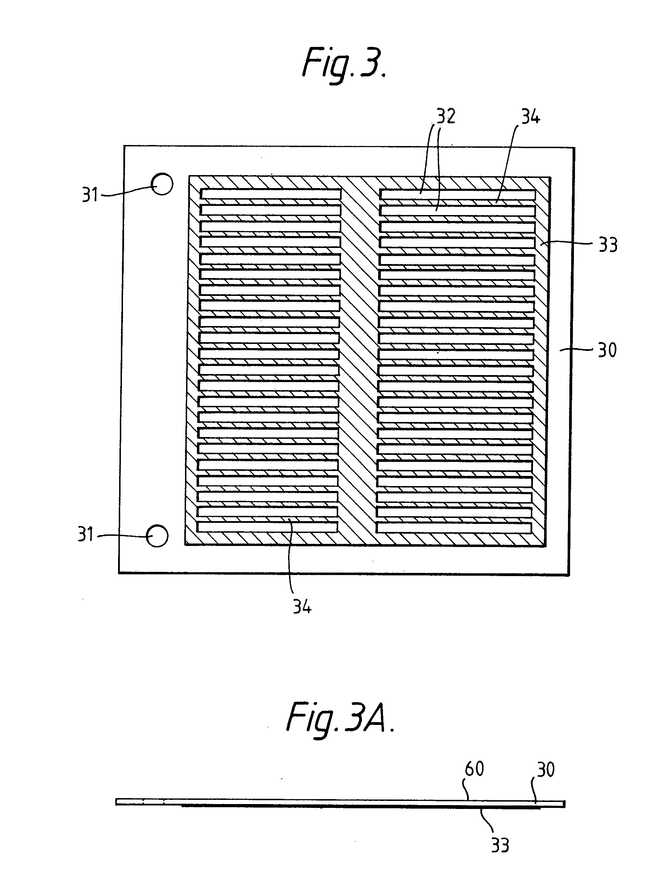

Thus Figures 3 and 3A show a ceramic lamina 30 having a pair of registration holes 31. The lamina 30 is formed with a grid-like arrangement of slots 32 and the area 33 around the slots is metallised by a screen printing process. The dimensions of the slots 32 are so chosen that the webs 34 between adjacent slots have a width equal to the width of the package wall through which the feed-through strips will pass when they are finally fabricated. For the feed-through strip shown in Figure 2 this width is x. On the reverse side of the lamina 30 a glass frit 60 is applied. This assists in providing hermeticity at lower firing temperatures which may be required if the metallising used is relatively thick. Thus in certain circumstances the glass frit can be dispensed with.

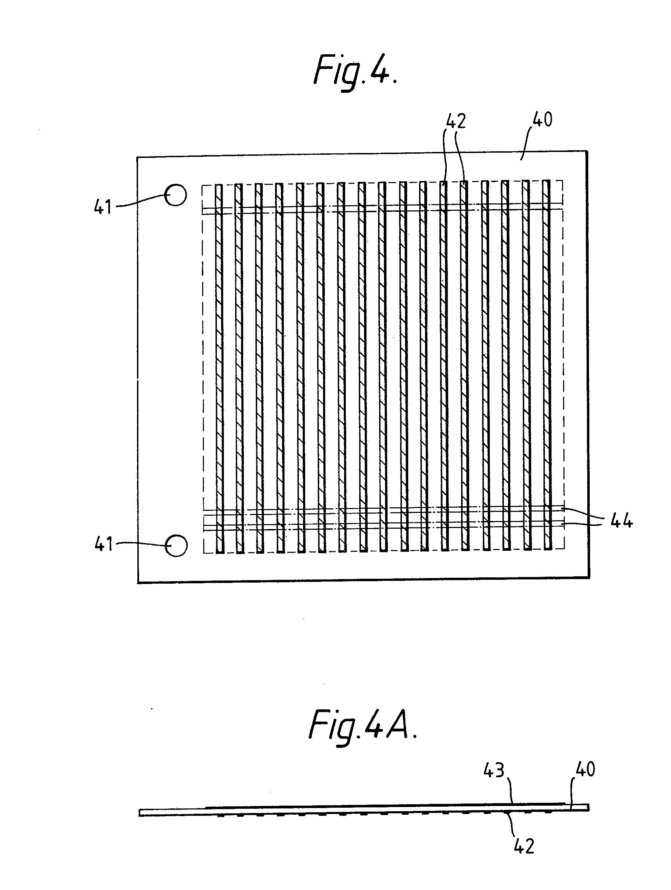

Referring now to Figures 4 and 4A of the drawings these show a second ceramic lamina 40 having registration holes 41. One surface of lamina 40 is metallised, again by a screen printing process, with parallel tracks 42 which each have a width equal to the required width of the final microstrip (21 in Figure 2) and spaced to allow for slitting into strips at a later stage in the process.

The reverse side of lamina 40 is metallised at 43 to give a continuous film so as to provide the metallising on face B of each of the final feed-throughs. After drying, a series of glass frit strips 44 are applied to the upper face of the lamina 40 to cross the metallised tracks 42 at right angles. The glass frit strips are arranged to coincide with the webs 34 of the lamina 30.

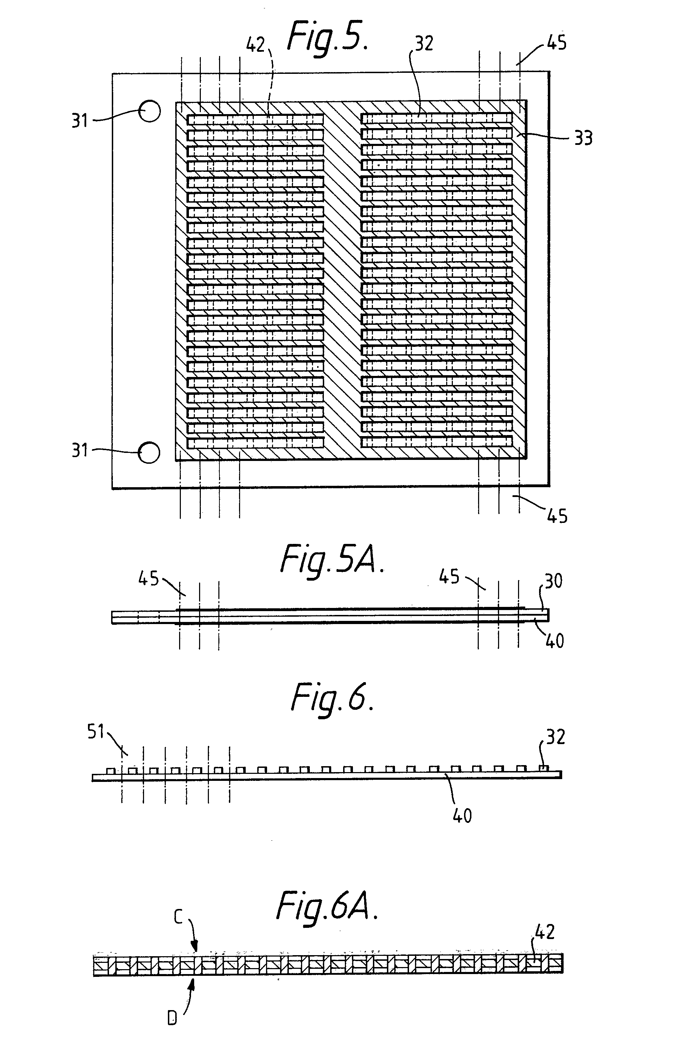

The laminae 30 and 40 are then brought together and registered by their respective registration holes 31 and 41 to form the sandwich-like body shown in Figures 5 and 5A. This body is then fired at a temperature which depends on the nature of the applied metallisation. Thus if a refractory metallisation has been used the firing temperature is high whilst if precious metal metallisation has been used a lower temperature is chosen. The choice of firing temperature will be readily apparent to any person skilled in the art.

The fired matrix formed by the two laminae is now ready to be divided into strips where indicated in Figures 5 and 5A by the broken lines 45. One such strip is shown in Figures 6 and 6A. However, before the matrix is cut into strips the registration between the two laminae is checked. A preferred method of cutting the matrix into strips is to use a very thin diamond-edged circular saw.

After the matrix has been slit into strips such as the one shown in Figure 6 each strip is metallised on its faces C and D. It is extremely important, bearing in mind low electrical leakage and characteristic impedance requirements, that this metallising does not spread around the edges to contaminate the unmetallised faces of the final feed-through. The strips are then individually fired at a temperature and a furnace atmosphere chosen to suit the type of metallising used throughout as described earlier. The strips are then rearranged into matrix form and clamped for subdivision into individual feed-throughs by slitting, again preferably with a diamond-edged saw, along the dotted lines 51.

It will be appreciated that the reference holes 31 and 41 in the two laminae have a number of functions beyond merely registering the two laminae to form the final matrix. Thus they are also used during the various screen printing operations and the formation of the slots in lamina 30. These slots can be cut by laser cutting.

The process just described can typically be used to fabricate some 200 individual feed-through strips from two laminae. Thus the fired matrix can be divided into 20 strips each having 10 potential individual feed-throughs.

## Claims

1. A process for the manufacture of microwave feed-through strips characterised by the steps of forming a first lamina (30) with a plurality of parallel slots (32) so as to define between the slots webs (34), metallising one side (33) of the lamina forming a second lamina (40), metallising one side of the second lamina (40) with parallel tracks (42) each having a width equal to the required width of the final microstrip, metallising the other side (43) of the lamina (40), placing the two laminae (30, 40) in registration, and firing the matrix so formed.

2. A process as claimed in Claim 1, and further characterised in that the matrix so formed is divided into strips (such as 51), and each strip so formed metallised on two faces.

3. A process as claimed in Claim 2, and further characterised in that the strips so formed are fired, rearranged into a matrix and sub-divided into individual feed-through strips.

4. A process as claimed in Claim 3, and further characterised in that the laminae (30, 40) are ceramic and have registration means (31, 41) whereby they can be placed in register.

5. A process as claimed in Claim 4, and further characterised in that the metallising of lamina (30) at (33) and of lamina (40) with tracks (42) is carried out by a screen printing process.

6. A microwave feed-through strip, and characterised in that it is manufactured by a process as claimed in any of the preceding claims.

*Fig.1.*

0250251

*Fig.2.*

*Fig.3.*

32  34

31

33

30

31

34

*Fig.3A.*

60  30

33

## Fig.4.

42  40

41

44

## Fig.4A.

43  40

42

*Fig.5.*

*Fig.5A.*

*Fig.6.*

*Fig.6A.*